# EUROPEAN PATENT SPECIFICATION

(11) **EP 3 908 087 B1**
(45) Date of publication and mention of the grant of the patent: **27.11.2024**
(21) Application number: 19927749.2
(22) Date of filing: 09.05.2019
(51) Int. Cl.: H05H 1/24

(54) **PLASMA IGNITION METHOD AND PLASMA GENERATION DEVICE**
PLASMAZÜNDVERFAHREN UND PLASMAGENERATOR
PROCÉDÉ D'ALLUMAGE PAR PLASMA ET DISPOSITIF DE GÉNÉRATION DE PLASMA

(43) Date of publication of application: 10.11.2021
(73) Proprietor: SPP Technologies Co., Ltd., Tokyo 100-0003 (JP)
(72) Inventor: LIAO, Bryan, Amagasaki-shi, Hyogo 660-0891 (JP)
(74) Representative: Wynne-Jones IP Limited
(86) International application number: PCT/JP2019/018622
(87) International publication number: WO 2020/225920

(56) References cited:
- JP-A- 2011 071 335
- JP-A- 2011 154 951
- JP-A- 2012 188 690
- JP-A- 2015 183 238
- JP-A- 2018 128 571
- JP-A- 2018 528 872
- JP-A- H09 180 896
- JP-A- S63 158 798
- US-A1- 2008 085 368

## Description

### [Technical Field]

The present invention relates to a method of igniting a plasma and a plasma generating system. In particular, the present invention relates to a method of igniting a plasma and a plasma generating system to quickly ignite a plasma without causing undesirable arcing.

### [Background Art]

A plasma generating system has conventionally been known, which includes a chamber to which a process gas is supplied, and a coil or an electrode attached to an upper part (on an upstream side in the direction of supply of the process gas) of the chamber for generating plasma. A plasma processing system has also been known, which includes the plasma generating system, and a mounting table attached to a lower part (on a downstream side in the direction of supply of the process gas) of the chamber, a substrate being mounted on the mounting table, the plasma processing system being configured to apply plasma processing on the substrate by using plasma generated by the process gas for an etching process, a deposition process, and the like. In a case in which the plasma generating system includes a coil, inductively coupled plasma is generated by applying a high frequency power to the coil. In a case in which the plasma generating system includes an electrode (upper electrode) disposed in parallel to the mounting table, capacitively coupled plasma is generated by applying a high frequency power to the electrode.

In the above-described plasma generating system, when the flow rate of the process gas supplied into the chamber is small and the pressure is low in the chamber, for example, it is known that plasma ignition (beginning of plasma generation) is difficult. It is conceivable to increase the pressure in the chamber in order to quickly ignite a plasma. However, a problem is that an excessively high pressure in the chamber degrades the uniformity of the plasma processing. It is also conceivable to first ignite a plasma at high pressure in the chamber, and thereafter switch to a low pressure. However, a problem is that the changing the pressure takes time, which lowers the productivity.

Accordingly, various methods have been proposed for igniting a plasma.

For example, Patent Literature 1 proposes a method of igniting a plasma by generating excimer laser light of at least about 10 MW in terms of a peak power, focusing the laser light in the chamber, and using dielectric breakdown caused by the laser light at the focused portion of the laser light to generate a spark.

However, with a demand for microfabrication with plasma processing in recent years, there is a need for reducing contamination and particle generation in the chamber during plasma processing. To this end, there is a need for a method of igniting a plasma without causing undesirable arcing such as a spark as in the case of Patent Literature 1. JP H09 180896 A discloses a plasma igniter comprising a laser device that can excite argon molecules in a vacuum chamber with laser light. JPS63158798 A discloses another plasma igniter using a high power laser beam.

### [Citation List]

### [Patent Literature]

[Patent Literature 1] JP8-10635B

### [Summary of Invention]

### [Technical Problem]

An object of the present invention, which has been made to solve the problem of the above-described related art, is to provide a method of igniting a plasma and a plasma generating system to quickly ignite a plasma without causing undesirable arcing.

### [Solution to Problem]

In order to solve the above-described problem, as a result of diligent study, the present inventors have found that, by using a semiconductor laser, the power of which is generally lower than the aforementioned 10MW excimer laser, and stopping emission of laser light from the semiconductor laser after the plasma is ignited, the plasma can be ignited in a short time without causing undesirable arcing in the chamber, and have completed the present invention. The reason why the plasma can still be ignited with a low power semiconductor laser is assumed to be that the process gas is subjected to multiphoton ionization.

That is, in order to solve the above-described problem, the present invention provides a method of igniting a plasma, comprising: a supplying step of supplying a process gas into a chamber provided in a plasma generating system; an igniting step of igniting a plasma by irradiating the process gas supplied into the chamber with laser light emitted from a semiconductor laser and applying a high frequency power to a coil or an electrode for generating plasma provided in the plasma generating system; and a stopping step of stopping emission of laser light from the semiconductor laser after the plasma is ignited.

According to the present invention, in the igniting step, the process gas is irradiated with laser light emitted from the semiconductor laser, and in the stopping step, emission of the laser light from the semiconductor laser is stopped after the plasma is ignited. Accordingly, plasma can be quickly ignited in the chamber without causing undesirable arcing as consistent with the above-described knowledge of the present inventors.

Advantageously, according to the present invention, a small and inexpensive semiconductor laser is used, so there are less restrictions for the assembly on which the semiconductor laser is installed and costs can be reduced.

Further advantageously, according to the present invention, in contrast to laser discharge in which plasma discharge is maintained by laser light, since emission of laser light from the semiconductor laser is stopped after the plasma is ignited, it is possible to prevent the semiconductor laser from being overheated and there is no need for cooling equipment.

It is to be noted that, in the present invention, the expression "stopping emission of laser light from the semiconductor laser after the plasma is ignited " is not limited to a case in which the emission of laser light is stopped after it is determined that ignition of plasma is actually made, but is a concept including stopping the emission of laser light at the timing when a predetermined period of time (for example, 2 seconds) has been reached or exceeded, the period of time being from the start of the emission of laser light or from the start of application of a high frequency power to the coil or the electrode until the ignition is properly made.

As a way of how to determine that plasma has actually been ignited, it is conceivable to determine that ignition is made when illumination is observed when visually checking the condition in the chamber, or to determine that the ignition is made when the amplitude of a reflected wave signal in an internal circuit or the like of a matching unit interposed between a high frequency power supply and the coil or the electrode falls to a predetermined value or less once a high frequency power is applied to the coil or the electrode. Instead of visually checking the condition in the chamber, it is also possible to detect the intensity of light generated in the chamber by a photodetector such as a photodiode or a phototransistor, a spectroscope, or the like, and to automatically determine that ignition is made when the intensity reaches a predetermined value or more.

Further, the "coil" in the present invention is not limited to a cylindrical coil, and a planar coil, a tornado coil, a three-dimensional coil, and the like may be used.

Preferably, in the igniting step, a high frequency power is started to be applied to the coil or the electrode after irradiation of the laser light is started.

According to a preferable method described above, when compared to a case in which laser light irradiation is started after the start of application of a high frequency power to the coil or the electrode, failure or the like of the plasma generating system can be prevented because the possibility of applying a high frequency power to the coil or the electrode in a state in which plasma is not ignited can be reduced.

Preferably, in the igniting step, the laser light is irradiated near the coil or the electrode.

Deposited film caused by reaction products in the chamber is less prevalent near the coil or the electrode and may be removed by sputtering in the case of the coil.

Accordingly, according to a preferable method described above, the possibility that laser light is absorbed or scattered by deposited film is reduced, so that the process gas can be irradiated with laser light of a desired intensity.

According to the knowledge of the present inventors, plasma is likely to be quickly ignited when laser light is irradiated at a location upstream of the cylindrical coil, in other words, laser light irradiation occurs at a location through which the process gas flows prior to reaching the inside of the cylindrical coil.

Therefore, preferably, the plasma generating system includes a cylindrical coil as the coil, and in the igniting step, the laser light is irradiated at a location upstream of the cylindrical coil.

According to a preferable method described above, it is possible to quickly ignite a plasma.

According to the knowledge of the present inventors, plasma is likely to be most quickly ignited when laser light is irradiated on a path passing obliquely from above the cylindrical coil toward below the cylindrical coil, among paths passing above the cylindrical coil (among paths passing a location upstream of the cylindrical coil).

Therefore, preferably, in the igniting step, the laser light is irradiated obliquely from above the cylindrical coil toward below the cylindrical coil.

According to a preferable method described above, it is possible to most quickly ignite a plasma.

Preferably, the laser light has a wavelength in a visible light range.

According to a preferable method described above, when compared to a case in which laser light having a wavelength in an ultraviolet light or infrared light region is used, inexpensiveness, easiness to perform adjustment work for optical axis adjustment or the like of the semiconductor laser, and excellence in safety can be obtained.

Preferably, the process gas is of at least one of the following gases: Cl₂ gas, O₂ gas, SF₆ gas, CF₄ gas, or C₄F₈ gas.

A highly electronegative gas such as Cl₂ gas, O₂ gas, SF₆ gas, CF₄ gas, or C₄F₈ gas is difficult to be turned into plasma.

Accordingly, the present invention can suitably be applied for a process gas which is highly electronegative as mentioned above.

Also, in order to solve the above-described problem, the present invention provides a plasma generating system, comprising: a chamber; a coil or an electrode for generating plasma; a semiconductor laser; and a controller, wherein the controller is capable of executing: a supplying step of supplying a process gas into the chamber; an igniting step of igniting a plasma by irradiating the process gas supplied into the chamber with laser light emitted from a semiconductor laser and applying a high frequency power to the coil or the electrode for generating plasma; and a stopping step of stopping emission of laser light from the semiconductor laser after the plasma is ignited.

### [Advantageous Effects of Invention]

According to the present invention, it is possible to quickly ignite a plasma without causing undesirable arcing.

### [Brief Description of Drawings]

Fig. 1 is a schematic view illustrating a schematic configuration of a plasma processing system according to an embodiment of the present invention in a partial cross-section view.
Fig. 2 is a timing chart schematically illustrating a procedure of a supplying step, an igniting step, and a stopping step of a method of igniting a plasma according to an embodiment of the present invention.
Figs. 3A and 3B are schematic views illustrating examples of other irradiation directions of laser light in the igniting step.
Figs. 4A and 4B are schematic views illustrating schematic configurations of other plasma generating systems to which the method of igniting a plasma according to the present invention is applicable in partial cross-section views.
Fig. 5 illustrates principal conditions and results of tests associated with examples and comparative examples of the present invention.

### [Description of Embodiments]

With reference to accompanying drawings, a plasma processing system including a plasma generating system according to an embodiment of the present invention and a method of igniting a plasma using the system will now be described.

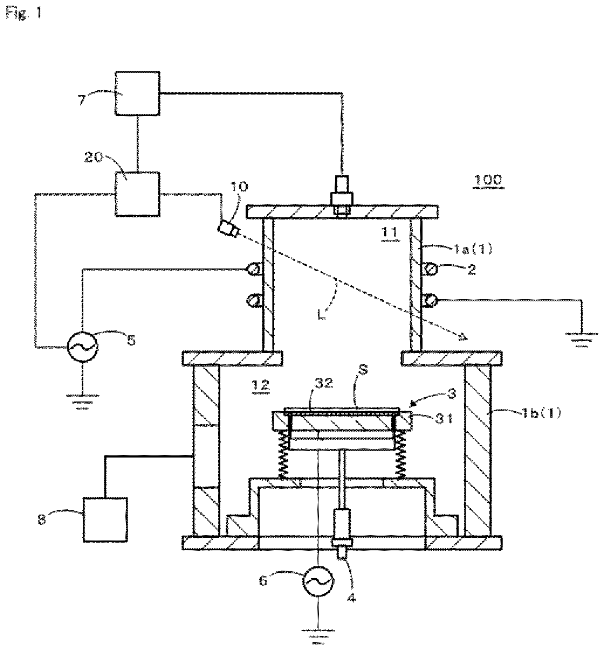

Fig. 1 is a schematic view illustrating a schematic configuration of a plasma processing system according to an embodiment of the present invention in a partial cross-section view.

As illustrated in Fig. 1, a plasma processing system 100 of the present embodiment includes a chamber 1, a coil 2 for generating plasma, a mounting table 3, a semiconductor laser 10, and a controller 20. The plasma generating system of the present embodiment is composed of the chamber 1 (an upper chamber 1a), the coil 2, the semiconductor laser 10, and the controller 20.

The chamber 1 is composed of the cylindrical upper chamber 1a and a cylindrical lower chamber 1b. A plasma generation space 11 to which process gas is supplied and plasma is generated is provided in the upper chamber 1a, and a plasma processing space 12 in which plasma processing is performed by generated plasma is provided in the lower chamber 1b. At least a portion of the upper chamber 1a through which laser light L emitted from the semiconductor laser 10 passes is formed of a material transparent to the wavelength of the laser light L. In the present embodiment, the entire upper chamber 1a is formed of a transparent material such as quartz.

The coil 2 is disposed outside the upper chamber 1a so as to surround the plasma generation space 11. The coil 2 of the present embodiment is a cylindrical coil (more specifically, a helical coil). However, the present invention is not limited thereto, and any other forms of coil can be applied, such as a planar coil, a tornado coil used in "Tornado ICP" available from Samco Inc., and a three-dimensional coil used in "Advanced-ICP" available from Panasonic Corporation. When a planar coil is used, the planar coil is disposed above the upper chamber 1a.

The mounting table 3 is disposed in the plasma processing space 12, and a substrate S to be subjected to plasma processing is mounted on the mounting table 3. The mounting table 3 may be attached to a lifting means (not illustrated) for vertically moving the mounting table 3, or may be fixed to the chamber 1 in a non-liftable manner. The mounting table 3 is provided with a mounting table body 31 formed of metal such as Al, and an electrostatic chuck 32 formed of a dielectric located on the mounting table body 31 and including an embedded electrode (not illustrated) connected to a DC power supply.

The plasma processing system 100 includes a lifting device 4 passing through the mounting table 3 and configured to vertically move lift pins, which are to come into contact with the bottom face of the substrate S, a high frequency power supply 5 connected to the coil 2 via a matching unit (not illustrated), a high frequency power supply 6 connected to the mounting table 3 (mounting table body 31) via a matching unit (not illustrated), a gas supply source 7, and an exhaust device 8.

The gas supply source 7 supplies a process gas for generating plasma to the plasma generation space 11. The high frequency power supply 5 applies a high frequency power to the coil 2. This allows the process gas supplied to the plasma generation space 11 to be turned into plasma, and inductively coupled plasma is generated. The high frequency power supply 6 applies a high frequency power to the mounting table body 31 of the mounting table 3. This allows the generated plasma to move toward the substrate S.

The exhaust device 8 exhausts gas in the chamber 1 to the outside of the chamber 1.

The substrate S to be subjected to plasma processing is transported from the outside of the chamber 1 into the chamber 1 by a transport mechanism (not illustrated), and mounted on the lift pins projected above the top face (the top face of the electrostatic chuck 32) of the mounting table 3. Subsequently, the lift pins are lowered by the lifting device 4, and thereby the substrate S is mounted on the mounting table 3 (electrostatic chuck 32). Once the plasma processing is completed, the lift pins are raised by the lifting device 4, and the substrate S is raised accordingly. The raised substrate S is to be transported to the outside of the chamber 1 by the transport mechanism.

The semiconductor laser 10 is disposed outside the upper chamber 1a such that the process gas supplied into the upper chamber 1a is irradiated with emitted laser light L. The semiconductor laser 10 of the present embodiment emits laser light L that has a wavelength in a visible light range (for example, 405 nm). However, the present invention is not limited thereto, and any other semiconductor lasers that emit laser light that has other wavelength such as a wavelength in the ultraviolet light region can be used. Although the semiconductor laser 10 of the present embodiment is of a continuous wave (CW) type, the present invention is not limited thereto, and a semiconductor laser of a pulsed mode type can be used to increase the energy density per unit time.

The semiconductor laser 10 of the present embodiment is provided with a lens (planar convex lens) disposed on the emission face side of laser light L such that emitted laser light L is to be parallel luminous flux. The laser light L thereby has substantially the same beam spot size throughout the path, and therefore, the process gas in any position is to be irradiated with the laser light L with substantially the same energy density neglecting the energy attenuation of the laser light L on the path.

The semiconductor laser 10 of the present embodiment is disposed such that the laser light L is irradiated near the coil 2. Specifically, the semiconductor laser 10 is disposed such that the laser light L is irradiated at a location upstream of the coil 2 (in the example illustrated in Fig. 1, the laser light L is upstream of the coil 2 on the left side of Fig. 1). More specifically, the semiconductor laser 10 is disposed such that the laser light L is obliquely irradiated from above the coil 2 toward below the coil 2 (in the example illustrated in Fig. 1, the laser light L is passing above the coil 2 on the left side of Fig. 1 and the laser light L is passing below the coil 2 on the right side of Fig. 1).

The controller 20 is electrically connected to the high frequency power supply 5, the gas supply source 7, and the semiconductor laser 10 and has a function of controlling the operation thereof. As the controller 20, PLC (Programmable Logic Controller) or a computer can be used.

Other components and operation of the plasma processing system 100 are similar to a general plasma processing system and therefore the detailed description will be omitted.

A method of igniting a plasma according to the present embodiment using thus configured plasma processing system 100 (plasma generating system) will now be described.

The method of igniting a plasma according to the present embodiment includes a supplying step, an igniting step, and a stopping step. The steps will each be described below in this order.

### <Supplying Step>

In the supplying step, the process gas is supplied from the gas supply source 7 into the plasma generation space 11 in the chamber 1 (upper chamber 1a). Specifically, in response to a control signal transmitted from the controller 20, an MFC (Mass Flow Controller) (not illustrated) is controlled, the MFC being provided in a tubing connecting the gas supply source 7 and the chamber 1 and configured to control the flow rate of the process gas. The process gas at a predetermined flow rate is supplied into the chamber 1.

In the present embodiment, for example, Cl₂ gas is used as the process gas. However, the present invention is not limited thereto, and various types of process gas can be used. In particular, since a highly electronegative gas such as Cl₂ gas, O₂ gas, SF₆ gas, CF₄ gas, or C₄F₈ gas is difficult to be turned into plasma, the method of igniting a plasma according to the present embodiment is effectively applicable.

### <Igniting Step>

In the igniting step, the process gas supplied into the chamber 1 is irradiated with the laser light L emitted from the semiconductor laser 10. Specifically, in response to a control signal transmitted from the controller 20, the power supply of the semiconductor laser 10 is turned on, causing the laser light L to be emitted.

Further, in the igniting step, a high frequency power is applied from the high frequency power supply 5 to the coil 2. Specifically, in response to a control signal transmitted from the controller 20, the high frequency power supply 5 is turned on, causing a high frequency power to be applied to the coil 2.

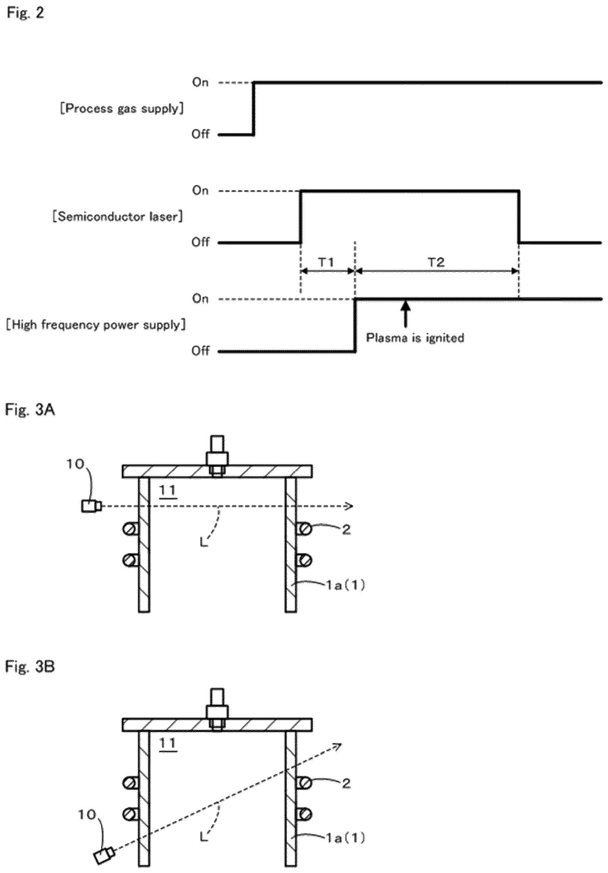

Fig. 2 is a timing chart schematically illustrating a procedure of the supplying step, the igniting step, and the stopping step of the present embodiment.

As illustrated in Fig. 2, in the igniting step of the present embodiment, after the supplying step is started (after "Process gas supply" illustrated in Fig. 2 is turned "On"), irradiation of the laser light L from the semiconductor laser 10 is started, and thereafter (after "Semiconductor laser" illustrated in Fig. 2 is turned "On"), application of a high frequency power from the high frequency power supply 5 to the coil 2 is started ("High frequency power supply" illustrated in Fig. 2 is turned "On"). Specifically, after time T1 has elapsed since the irradiation of the laser light L was started, the application of the high frequency power to the coil 2 is started. For example, the time T1 is about 0.5 to 1.0 seconds. The irradiation of the laser light L may be started before the supplying step is started.

### <Stopping Step>

In the stopping step, after the plasma is ignited, emission of the laser light L from the semiconductor laser 10 is stopped. Specifically, in response to a control signal transmitted from the controller 20, the power supply of the semiconductor laser 10 is turned off, causing the emission of the laser light L to be stopped.

As illustrated in Fig. 2, in the present embodiment, period of time T2 from the start of the application of the high frequency power to the coil 2 until the ignition is properly made is determined in advance and the period of time T2 is set and stored in the controller 20. After the start of the application of the high frequency power to the coil 2, the controller 20 transmits a control signal for turning off the power supply of the semiconductor laser 10 at the timing when the set and stored period of time T2 is reached. For example, the period of time T2 is about 2.0 to 3.0 seconds.

However, the present invention is not limited thereto, and it is possible to adopt stopping the emission of the laser light L after it is determined that plasma has actually been ignited.

For example, it is conceivable to provide a sensor for detecting the amplitude of a reflected wave signal in an internal circuit or the like of a matching unit (not illustrated) interposed between the high frequency power supply 5 and the coil 2 once a high frequency power is applied to the coil 2, to input an output signal of the sensor to the controller 20, and to determine that ignition is made when the amplitude of the reflected wave signal detected by the controller 20 through the sensor falls to a predetermined value or less. It is also conceivable to provide a spectroscope or the like for detecting the intensity of light generated in the chamber 1, to input the intensity of light detected by the spectroscope or the like to the controller 20, and to determine that ignition is made when the intensity of light detected by the controller 20 reaches a predetermined value or more.

According to the method of igniting a plasma according to the present embodiment described above, since in the igniting step, the process gas is irradiated with the laser light L emitted from the semiconductor laser 10, and in the stopping step, after the plasma is ignited, the emission of the laser light L from the semiconductor laser 10 is stopped, it is possible to quickly ignite a plasma in the chamber 1 without causing undesirable arcing.

Further, in the igniting step, the application of the high frequency power to the coil 2 is started after the start of the irradiation of the laser light L. Therefore, when compared to a case in which the irradiation of the laser light L is started after the start of the application of the high frequency power to the coil 2, the possibility of applying a high frequency power to the coil 2 in a state in which plasma is not ignited can be reduced. In this way, it is possible to prevent failure or the like of the plasma processing system 100.

Further, since in the igniting step, the laser light L is irradiated near the coil 2 where reaction products in the chamber 1 are less likely to remain as deposited film, the possibility that the laser light L is absorbed or scattered by the deposited film is reduced, so that the process gas can be irradiated with the laser light L of a desired intensity.

Further, since in the igniting step, the laser light L is obliquely irradiated from above the coil 2 toward below the coil 2, it is possible to most quickly ignite a plasma.

Figs. 3A and 3B are schematic views illustrating examples of other irradiation directions of the laser light L in the igniting step. Figs. 3A and 3B each illustrate only near the upper chamber 1a.

In the example illustrated in Fig. 1, although the description has been made as to a mode in which in the igniting step, the laser light L is obliquely irradiated from above the coil 2 toward below the coil 2, the present invention is not limited thereto. For example, as illustrated in Fig. 3A, it is possible to irradiate the laser light L on a horizontal path passing above the coil 2. Further, as illustrated in Fig. 3B, it is possible to obliquely irradiate the laser light L from below the coil 2 toward above the coil 2.

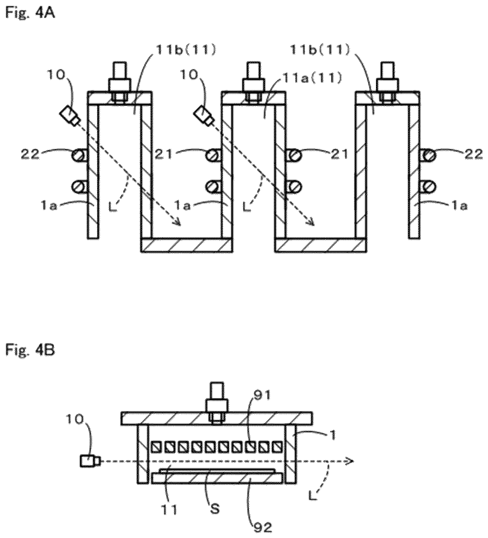

Figs. 4A and 4B are schematic views illustrating schematic configurations of other plasma generating systems to which the method of igniting a plasma according to the present invention is applicable in partial cross-section views.

In the plasma generating system illustrated in Fig. 4A, plasma generation spaces 11 in two locations (inner plasma generation space 11a and outer plasma generation space 11b) are formed by the upper chamber 1a, and the process gas is supplied to each of the plasma generation spaces 11. The coil is composed of an inner coil 21 and an outer coil 22 disposed in a concentric manner with respect to the coil 21. The process gas supplied to the plasma generation spaces 11 in two locations of the plasma generating system illustrated in Fig. 4A is irradiated with the laser light L, each beam of which is emitted from two semiconductor lasers 10.

As with Fig. 1, although in Fig. 4A, the illustration has been made as to a mode in which the laser light L is obliquely irradiated from above the coil 21 or 22 toward below the coil 21 or 22, the present invention is not limited thereto. As with Fig. 3A, it is possible to irradiate the laser light L on a horizontal path passing above the coil 21 or 22. Further, as with Fig. 3B, it is possible to obliquely irradiate the laser light L from below the coil 21 or 22 toward above the coil 21 or 22. Further, in Fig. 4A, a semiconductor laser 10 for irradiating the laser light L to the inner plasma generation space 11a and another semiconductor laser 10 for irradiating the laser light L to the outer plasma generation space 11b are disposed, and it is preferable to dispose two or more semiconductor lasers 10 depending on the number of plasma generation spaces 11 in this way in order to increase margin for plasma ignition. However, the inner plasma generation space 11a and the outer plasma generation space 11b are in communication with each other, and therefore, the plasma is to be dispersed between the plasma generation spaces 11. Accordingly, it is still possible to quickly ignite a plasma with a configuration in which only a semiconductor laser 10 for irradiating the laser light L to the inner plasma generation space 11a is disposed, or a configuration in which only a semiconductor laser 10 for irradiating the laser light L to the outer plasma generation space 11b is disposed. Further, the plasma generating system may not necessarily have the inner plasma generation space 11a illustrated in Fig. 4A and may have only the outer plasma generation space 11b.

The plasma generating system illustrated in Fig. 4B is a parallel-plate plasma generating system including a shower head-type upper electrode 91 provided with a number of holes for passing the process gas and a lower electrode 92 on which the substrate S is mounted, the electrodes being disposed in parallel with each other. Applying a high frequency power to the upper electrode 91 of the plasma generating system causes capacitively coupled plasma to be generated in the plasma generation space 11. In the case of the plasma generating system illustrated in Fig. 4B, the process gas supplied to the plasma generation space 11 is irradiated with the laser light L emitted from the semiconductor laser 10.

In the example illustrated in Fig. 4B, although illustration has been made as to a mode in which the laser light L is irradiated on a horizontal path passing between the upper electrode 91 and the lower electrode 92, this is not necessarily a limitation, and the irradiation may be made on a path from above the upper electrode 91 toward below the upper electrode 91 if it is possible in view of equipment.

Examples and comparative examples of the present invention will now be described.

Tests for evaluating time taken to ignite a plasma was conducted by using the plasma generating system and the irradiation direction of the laser light L illustrated in Fig. 1 and Fig. 3A for Examples 1 to 8, while conditions such as gas flow rate, pressure in the chamber 1, and power density of a high frequency power applied to the coil 2 were changed. In all test cases, Cl₂ gas was used for the process gas. For the semiconductor laser 10, a CW (continuous) type semiconductor laser that could emit the laser light L having a wavelength of 405 nm at an optical power of 20 mW. A planar convex lens was disposed on the emission face side of the semiconductor laser 10 used in the tests, which allowed the laser light L that was parallel luminous flux and had a beam spot size of about 2 to 3 mm to be emitted. With the beam spot size of 2 to 3 mm, the irradiance of the laser light L reaches 2.2×10³ to 5.0×10³ W/m².

For comparative examples 1 to 8, tests for evaluating time taken to ignite a plasma were conducted without irradiation of the laser light L. The comparative examples 1 to 8 were each conducted under the same conditions as that of Examples 1 to 8, the number of which corresponds to the comparative example, excepting the fact that the laser light L was not irradiated.

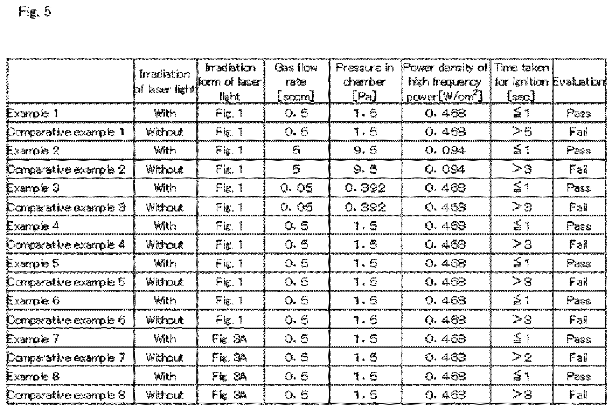

Fig. 5 illustrates principal conditions and results of the tests. In the tests, the condition in the chamber 1 was visually checked, and it was determined that ignition was made when illumination was observed. The period of time from the start of the application of a high frequency power to the coil 2 until the ignition was made was defined for evaluation as time taken for ignition. The "power density of high frequency power" in Fig. 5 refers to "the high frequency power applied to the coil 2" divided by "the surface area of an inner surface of the chamber 1 contacted by the plasma".

As illustrated in Fig. 5, in any of Examples 1 to 8, the time taken to ignite a plasma was 1 second or less, and therefore, plasma could be quickly ignited. Further, no undesirable arcing occurred during ignition of plasma. In contrast, in comparative examples 1 to 8, the time taken to ignite a plasma exceeded at least 2 seconds, and therefore, plasma could not be quickly ignited.

Although all of Examples 1 to 8 took no more than 1 second to ignite a plasma, Examples 1 to 6 (the irradiation direction of the laser light L being illustrated in Fig. 1) ignited the plasma several tenths of a second faster than Examples 7 and 8 (the irradiation direction of the laser light L being illustrated in Fig. 3A). The reason why ignition is likely to be made most quickly in the case of the laser light irradiation direction illustrated in Fig. 1 is assumed to be (a) and (b) below.
(a) In the case of the irradiation direction of the laser light L illustrated in Fig. 1, since the laser light L is obliquely irradiated from above the coil 2 toward below the coil 2, the laser light L may pass through the center of the coil 2, where it is considered that the strength of the electromagnetic field is at the highest and therefore the generation of plasma is facilitated.
(b) The energy density of the laser light L reaches the highest on the entry side to the plasma generation space 11. In the case of the irradiation direction of the laser light L illustrated in Fig. 1, since the entry side where the energy density of the laser light L reaches the highest is located upstream of the coil 2, it is considered that the probability of generation of plasma increases because the process gas located in the upper part in the coil 2 is irradiated with the laser light L which has high energy density.

### [Reference Signs List]

- 1: chamber
- 2: coil
- 10: semiconductor laser
- 20: controller
- 91: electrode (upper electrode)
- 100: plasma processing system
- L: laser light

## Claims

1. A method of igniting a plasma, comprising:
a supplying step of supplying a process gas into a chamber (11) provided in a plasma generating system (100);
an igniting step of igniting a plasma by irradiating the process gas supplied into the chamber with laser light (L) emitted from a semiconductor laser (10) and applying a high frequency power to a coil (2) or an electrode for generating plasma provided in the plasma generating system; and
a stopping step of stopping emission of laser light from the semiconductor laser after the plasma is ignited.

2. The method of igniting a plasma according to claim 1, wherein
in the igniting step, a high frequency power is started to be applied to the coil or the electrode after irradiation of the laser light is started.

3. The method of igniting a plasma according to claim 1 or 2, wherein
in the igniting step, the laser light is irradiated near the coil or the electrode.

4. The method of igniting a plasma according to any one of claims 1 to 3, wherein
the plasma generating system includes a cylindrical coil as the coil, and
in the igniting step, the laser light is irradiated at a location upstream of the cylindrical coil.

5. The method of igniting a plasma according to claim 4, wherein
in the igniting step, the laser light is irradiated obliquely from above the cylindrical coil toward below the cylindrical coil.

6. The method of igniting a plasma according to any one of claims 1 to 5, wherein
the laser light has a wavelength in a visible light range.

7. The method of igniting a plasma according to any one of claims 1 to 6, wherein
the process gas is of at least one of the following gases: Cl₂ gas, O₂ gas, SF₆ gas, CF₄ gas, or C₄F₈ gas.

8. A plasma generating system, comprising:
a chamber (11)
a coil (2) or an electrode for generating plasma;
a semiconductor laser (10); and
a controller (20),
wherein the controller is configured to execute
a supplying step of supplying a process gas into the chamber;
an igniting step of igniting a plasma by irradiating the process gas supplied into the chamber with laser light emitted from a semiconductor laser and applying a high frequency power to the coil or the electrode for generating plasma; and
a stopping step of stopping emission of laser light from the semiconductor laser after the plasma is ignited.

## Patentansprüche

1. Verfahren zum Zünden eines Plasmas, umfassend:
einen Zufuhrschritt zum Zuführen eines Prozessgases in eine Kammer (11), die in einem Plasmaerzeugungssystem (100) bereitgestellt ist;
einen Zündschritt zum Zünden eines Plasmas durch ein Bestrahlen des Prozessgases, das in die Kammer zugeführt wird, mit Laserlicht (L), das von einem Halbleiterlaser (10) emittiert wird, und ein Anlegen einer Hochfrequenzleistung an eine Spule (2) oder eine Elektrode zum Erzeugen von Plasma, bereitgestellt in dem Plasmaerzeugungssystem; und
einen Stoppschritt zum Stoppen von Emission von Laserlicht von dem Halbleiterlaser, nachdem das Plasma gezündet wurde.

2. Verfahren zum Zünden eines Plasmas nach Anspruch 1, wobei
in dem Zündschritt begonnen wird, eine Hochfrequenzleistung an die Spule oder die Elektrode anzulegen, nachdem mit der Bestrahlung des Laserlichts begonnen wurde.

3. Verfahren zum Zünden eines Plasmas nach Anspruch 1 oder 2, wobei
in dem Zündschritt, das Laserlicht in die Nähe der Spule oder der Elektrode gestrahlt wird.

4. Verfahren zum Zünden eines Plasmas nach einem der Ansprüche 1 bis 3, wobei
das Plasmaerzeugungssystem eine zylindrische Spule als die Spule umfasst, und
in dem Zündschritt, das Laserlicht an einer Stelle stromaufwärts der zylindrischen Spule gestrahlt wird.

5. Verfahren zum Zünden eines Plasmas nach Anspruch 4, wobei
in dem Zündschritt, das Laserlicht schräg von oberhalb der zylindrischen Spule nach unterhalb der zylindrischen Spule gestrahlt wird.

6. Verfahren zum Zünden eines Plasmas nach einem der Ansprüche 1 bis 5, wobei
das Laserlicht eine Wellenlänge in einem sichtbaren Lichtbereich aufweist.

7. Verfahren zum Zünden eines Plasmas nach einem der Ansprüche 1 bis 6, wobei
das Prozessgas mindestens eines der folgenden Gase ist: Cl₂-Gas, O₂-Gas, SF₆-Gas, CF₄-Gas oder C₄F₈-Gas.

8. Plasmaerzeugungssystem, umfassend:
eine Kammer (11)
eine Spule (2) oder eine Elektrode zum Erzeugen von Plasma;
ein Halbleiterlaser (10); und
eine Steuerung (20),
wobei die Steuerung konfiguriert ist, um auszuführen
einen Zufuhrschritt zum Zuführen eines Prozessgases in die Kammer;
einen Zündschritt zum Zünden eines Plasmas durch das Bestrahlen des Prozessgases, das in die Kammer zugeführt wird, mit Laserlicht, das von einem Halbleiterlaser emittiert wird, und das Anlegen einer Hochfrequenzleistung an die Spule oder die Elektrode zum Erzeugen von Plasma; und
einen Stoppschritt zum Stoppen von Emission von Laserlicht von dem Halbleiterlaser, nachdem das Plasma gezündet wurde.

## Revendications

1. Procédé d'allumage d'un plasma, comprenant :
une étape d'alimentation consistant à alimenter un gaz de traitement dans une chambre (11) prévue dans un système de génération de plasma (100) ;
une étape d'allumage consistant à allumer un plasma en irradiant le gaz de traitement alimenté dans la chambre avec la lumière laser (L) émise par un laser à semi-conducteur (10) et en appliquant une puissance à haute fréquence à une bobine (2) ou à une électrode pour générer du plasma dans le système de génération de plasma ; et
une étape d'arrêt consistant à arrêter l'émission de lumière laser par le laser à semi-conducteur après l'allumage du plasma.

2. Procédé d'allumage d'un plasma selon la revendication 1, dans lequel
durant l'étape d'allumage, une puissance à haute fréquence commence à être appliquée à la bobine ou à l'électrode après le début de l'irradiation de la lumière laser.

3. Procédé d'allumage d'un plasma selon la revendication 1 ou 2, dans lequel
durant l'étape d'allumage, la lumière laser est irradiée à proximité de la bobine ou de l'électrode.

4. Procédé d'allumage d'un plasma selon l'une quelconque des revendications 1 à 3, dans lequel
le système de génération de plasma comporte une bobine cylindrique en tant que bobine, et
durant l'étape d'allumage, la lumière laser est irradiée à un emplacement situé en amont de la bobine cylindrique.

5. Procédé d'allumage d'un plasma selon la revendication 4, dans lequel
durant l'étape d'allumage, la lumière laser est irradiée obliquement du haut de la bobine cylindrique vers le bas de la bobine cylindrique.

6. Procédé d'allumage d'un plasma selon l'une quelconque des revendications 1 à 5, dans lequel
la lumière laser a une longueur d'onde dans un spectre de la lumière visible.

7. Procédé d'allumage d'un plasma selon l'une quelconque des revendications 1 à 6, dans lequel
le gaz de traitement est au moins l'un des gaz suivants : gaz Cl₂, gaz O₂, gaz SF₆, gaz CF₄, ou gaz C₄F₈.

8. Système de génération de plasma comprenant :
une chambre (11)
une bobine (2) ou une électrode pour générer du plasma ;
un laser àsemi-conducteur (10) ; et
un dispositif de commande (20),
dans lequel le dispositif de commande est configuré pour exécuter
une étape d'alimentation d'un gaz de traitement dans la chambre ;
une étape d'allumage consistant à allumer un plasma en irradiant le gaz de traitement alimenté dans la chambre avec une lumière laser émise par un laser à semi-conducteur et en appliquant une puissance à haute fréquence à la bobine ou à l'électrode pour générer un plasma ; et
une étape d'arrêt consistant à arrêter l'émission de lumière laser par le laser à semi-conducteur après l'allumage du plasma.
